# EUROPÄISCHE PATENTSCHRIFT

(11) **EP 0 907 764 B1**
(45) Veröffentlichungstag und Bekanntmachung des Hinweises auf die Patenterteilung: **30.08.2000**
(21) Anmeldenummer: 97924878.8
(22) Anmeldetag: 09.05.1997
(51) Int. Cl.: C23C 30/00, C23C 16/30

(54) **SCHNEIDWERKZEUG UND VERFAHREN ZU SEINER HERSTELLUNG**
CUTTING TOOL AND MANUFACTURING METHOD THEREFOR
OUTIL DE COUPE ET SON PROCEDE DE FABRICATION

(30) Priorität: 07.06.1996 DE 19622823
(43) Veröffentlichungstag der Anmeldung: 14.04.1999
(73) Patentinhaber: Widia GmbH, 45145 Essen (DE)
(72) Erfinder: SOTTKE, Volkmar, D-45479 Mülheim (DE); WESTPHAL, Hartmut, D-36466 Dermbach (DE)
(74) Vertreter: Vomberg, Friedhelm, Dipl.-Phys.
(86) Internationale Anmeldenummer: DE9700958
(87) Internationale Veröffentlichungsnummer: WO9747785

(56) Entgegenhaltungen:
- WO-A-97/04142
- DE-A- 19 518 927
- GB-A- 663 377
- US-A- 5 282 985
- PATENT ABSTRACTS OF JAPAN vol. 007, no. 093 (P-192), 19.April 1983 & JP 58 019739 A (SONY KK), 4.Februar 1983,

## Beschreibung

Die Erfindung betrifft ein Schneidwerkzeug, bestehend aus einem Substratkörper und mindestens einer hierauf abgeschiedenen Schicht, die im wesentlichen aus Carbiden, Nitriden, Carbonitriden, Oxicarbonitriden, Oxiden und/oder Boriden mindestens eines der Elemente der IVa- bis VIa-Gruppe des Periodensystemes oder aus einer Keramik, vorzugsweise Al₂O₃ besteht.

Die Erfindung betrifft ferner ein Verfahren zur Herstellung eines solchen Schneidwerkzeuges, bei dem auf einem Substratkörper aus der Gasphase eine oder mehrere Schichten mittels PVD, CVD oder PCVD abgeschieden werden.

Die Beschichtung von Substratkörpern aus Hartmetall, einem Cermet, einer Keramik oder Stahl mit Hartstoffen oder Hartstoffmischungen ist nach dem Stand der Technik bekannt.

Beispielsweise wird in der US-A-4 619 866 ein Verfahren zur Herstellung eines Substratkörpers aus einem Hartmetall oder einer Keramik mit einer Al₂O₃-Beschichtung beschrieben, bei dem der Substratkörper einer Gasphase mit einem oder mehreren Metallhalogeniden bei 700°C bis 1200°C in einem CVD-Verfahren ausgesetzt wird. Zur Erhöhung des Schichtwachstums der Al₂O₃-Schicht wird der Gasphase in einer Menge von 0,03 bis 1 Vol.-% ein Stoff zugegeben, der aus der Gruppe Schwefel, Selen, Tellur, Phosphor, Arsen, Antimon, Wismut oder Mischungen hieraus ausgewählt wird. Beispielhaft wird die Zugabe von H₂S angegeben, die sowohl zu einer Erhöhung der Abscheidegeschwindigkeit als auch zur Abscheidung von α- und κ-Aluminiumoxid führen soll. Verfahrenstechnisch ist jedoch die Verwendung von H₂S sowohl wegen der extrem unangenehmen Geruchsbelästigung als auch der sich ergebenden, die Anlage kontaminierenden H₂S-Spaltprodukte nachteilig. Entsprechendes gilt auch für das in der EP 0 523 021 A1 beschriebene Verfahren, mit dem ein Substratkörper mit mindestens einem Carbid, Nitrid, Carbonitrid oder Oxicarbonitrid eines Elementes der IVa- bis VIa-Gruppe des Periodensystemes beschichtet werden soll, wozu im Reaktionsgas u.a. 0,4 % H₂S zugegeben werden soll.

Zur Erzeugung einer rißfreien Oberflächenbeschichtung wird weiterhin in der EP 0 659 903 A1 vorgeschlagen, der Gasatmosphäre, die CO₂, CO und AlCl₃ neben Wasserstoff enthält, SF₆ in einer Menge von 0,2 % neben 4 % HCl, Rest jeweils Wasserstoff, beizugeben.

Die EP 0 534 905 A2 beschreibt ein Werkzeug für die Zerspanungsbearbeitung von Werkstoffen, das eine Oberflächenschicht aus mindestens einer Verbindung aus mindestens einem Hauptgruppenelement der VI. Gruppe des periodischen Systemes einerseits und mindestens einem Nebengruppenelement der V. und VI. Gruppe des periodischen Systemes andererseits enthalten soll. Als Schichtsubstrate werden insbesondere Molybdändisulfid mit stöchiometrischer oder nichtstöchiometrischer Zusammensetzung vorgeschlagen.

Die DE 195 18 927 A1 offenbart ein Sinterkarbid- oder Keramik-Substrat mit einem verschleißfesten Verbundkeramik-Überzug, der eine dotierte Zwei-Phasen-Metalloxidschicht aus einer vollständig dichten zusammenhängenden kontinuierlichen Metalloxidphase und einer vollständig dichten zusammenhängenden diskontinuierlichen Metalloxidphase aufweist. Die beiden genannten Phasen bestehen aus unterschiedlichen Oxiden der Elemente Aluminium, Yttrium oder Zirkonium.

Es ist Aufgabe der vorliegenden Erfindung, ein Schneidwerkzeug der eingangs genannten Art zu schaffen und zu dessen Herstellung ein Verfahren anzugeben, der eine erhöhte Verschleißfestigkeit aufweist.

Diese Aufgabe wird durch das Schneidwerkzeug nach Anspruch 1 gelöst, der erfindungsgemäß dadurch gekennzeichnet ist, daß die einzige Schicht oder bei mehreren Schichten zumindest die äußerste Schicht eine dispersive zweite Phase aus mindestens einem Titansulfid und/oder Titanselenid enthält. Die erste Phase besteht aus Carbiden, Nitriden, Carbonitriden, Oxicarbonitriden, Oxiden und/oder Boriden mindestens eines der IVa- bis VIa-Elemente des Periodensystemes oder aus einer Keramik, also Hartstoffen, die grundsätzlich nach dem Stand der Technik seit langem bekannt sind. Durch Co-Abscheidung dieser Hartstoffe zusammen mit den genannten Sulfiden und/oder Seleniden wird ein Schmierstoff in der einzigen oder der äußersten Schicht impletiert, der als Schmierstoffdepot dient, das auch nach anfänglichem Verschleiß entsprechend der Schmierstoff-Dotierungsmenge in der Schichtmatrix vorliegt. Hierdurch können die Verschleißeigenschaften der jeweiligen äußeren Schichten im wesentlichen erhalten bleiben und entsprechend der Sulfid- oder Selenid-Dotierungsmenge mit wünschenswerten Schmierstoff-Eigenschaften kombiniert werden. Beim Einsatz der erfindungsgemäßen Schneidwerkzeuge, kann je nach Zerspanungsvorgang auch ganz oder zumindest teilweise auf die Verwendung von Kühlschmiermitteln, deren Entsorgung aus Umweltschutzgründen problematisch ist, verzichtet werden.

Der Anteil der zweiten Phase in der einzigen oder der äußersten Schicht sowie ggf. weiteren Schichten soll 20 Massen-%, vorzugsweise bis zu 5 Massen-% maximal nicht übersteigen. Bei den meisten Anwendungszwecken reicht es sogar aus, den Anteil der zweiten Phase auf 2 Massen-%, vorzugsweise 1 Massen-%, zu begrenzen.

Bevorzugtes Mittel für die zweite Phase ist TiSₓ mit x = 1 bis 2, vorzugsweise 1,5 bis 2. Die entsprechende stöchiometrische oder unterstöchiometrische Einstellungen des Schwefelgehaltes kann durch den Gasanteil des Schwefels in der Gasphase, aus der das Titansulfid abgeschieden wird, beeinflußt werden.

Im Rahmen der vorliegenden Erfindung ist es sowohl möglich, die zweite Phase in der jeweiligen Oberflächenschicht des Schneidwerkzeuges homogen als auch inhomogen im Sinne eines Verteilungsgradienten einzustellen. Unter einer homogenen Verteilung ist zu verstehen, daß sich pro Volumeneinheit der betreffenden Oberflächenschicht gleiche Mengen an Sulfiden und/oder Seleniden in diesen Volumeneinheiten befinden. Ein Gradientenverlauf wird vorzugsweise derart gewählt, daß in den oberflächennahen Zonen ein höherer Sulfid- und/oder Selenidanteil vorliegt als in darunterliegenden Schichten. Insbesondere kann der Anteil der zweiten Phase in einer Eindringtiefe bis 1 bis 2 µm von der Oberfläche aus bis zu 50 % betragen und in einer größeren Eindringtiefe der äußersten Schicht stufenweise oder kontinuierlich abnehmen. Die extrem mit dem Sulfid und/oder Selenid angereicherte äußerste oberflächennahe Zone läßt sich dann dazu ausnutzen, den Initialverschleiß bei Zerspanungsoperationen zu kontrollieren, d.h. beim Anlaufen des Dreh-, Fräs- oder Bohrvorganges Werkzeug-Verschleißzonen mit erhöhtem Schmiermittelgehalt zur Verfügung zu stellen. Nach dem Anlaufen des Zerspanungsvorganges minimiert sich bekanntlich der Verschleiß, so daß entsprechend der dann in geringerem Maße notwendigen Schmierung des Werkzeuges auch der Bedarf an Schmiermittel absinkt. Dem kann durch Gradienteneinstellung Rechnung getragen werden.

Nach einer weiteren Variante der Erfindung können bis zu 60 % der Selenide und/oder Sulfide durch Oxide derselben Metalle ersetzt werden.

Vorzugsweise und wie grundsätzlich nach dem Stand der Technik bekannt, wird eine mindestens zweilagige Beschichtung gewählt, bei der die erste, substratnächste Schicht aus TiN als diffusionshemmender Schicht besteht. Diese Schicht hat vorzugsweise eine Dicke von 1 bis 2 µm. Die Gesamtdicke der aufgetragenen Schichten liegt im Bereich von 2 bis 20 µm, wobei die Dicke der äußersten Schicht 8µm betragen sollte.

Verfahrenstechnisch wird die eingangs genannte Aufgabe dadurch gelöst, daß in der Gasphase des PVD, CVD oder PCVD-Prozesses bei der Abscheidung der einzigen oder der letzten Schicht Schwefel- und/oder Selenverbindungen enthalten sind. Vorzugsweise werden zur Co-Abscheidung der Hartstoffe und des TiSₓ als Schmierstoff in die Gasphase TiCl₄ und SF₆ oder SF₄ eingeleitet. Die betreffende Gaszusammensetzung des PVD-, CVD- oder PCVD-Prozesses kann entweder bei der Abscheidung der zweiphasigen einzigen oder letzten Schicht konstant aufrechterhalten werden oder im Sinne einer Gradienteneinstellung variiert werden. Will man zu oberflächennäheren Zonen hin den prozentualen Anteil der zweiten Phase - des Schmiermittels - erhöhen, wird in entsprechender Weise der prozentuale Anteil der Schwefel- und/oder Selenverbindungen in der Gasphase stufenweise oder kontinuierlich erhöht.

Nach einem konkreten Ausführungsbeispiel der vorliegenden Erfindung ist als Substratkörper ein Hartmetall aus 94 Massen-% WC und 6 Massen-% CO verwendet worden. Auf diesen Substratkörper ist zunächst mittels eines CVD-Verfahrens TiN in einer Dicke von 1 µm aufgetragen worden. Diese TiN-Schicht dient als Diffusionssperre zwischen dem Substratkörper und der äußeren Schicht, die im vorliegenden Fall als 8 µm dicke Al₂O₃-Schicht mit einer TiSₓ-Dotierung aufgetragen worden ist. Hierzu sind folgende Stoffe unter einem Druck von 80 mbar und einer Temperatur von 1000°C in die Gasatmosphäre eingeleitet worden: 10 l AlCl₃, 3 l TiCl₄, 15 l CO₂, 0,5 bis 1 l SF₆, Rest H₂ in einer Menge von insgesamt 460 1. Die äußere Al₂O₃-Schicht enthielt als zweite Phase einen TᵢSₓ-Anteil je nach Schwefelfluoridanteil zwischen 1 % und 2 %. Die Wachstumsgeschwindigkeit der Aluminiumoxid-Schicht betrug 3 bis 5 µm/h.

## Patentansprüche

1. Schneidwerkzeug, bestehend aus einem Substratkörper und mindestens einer hierauf abgeschiedenen Schicht, die im wesentlichen aus Carbiden, Nitriden, Carbonitriden, Oxicarbonitriden, Oxiden und/oder Boriden mindestens eines der Elemente der IVa- bis VIa-Gruppe des Periodensystemes oder aus einer Keramik, vorzugsweise Al₂O₃ besteht,
**dadurch gekennzeichnet,**
daß die einzige Schicht oder bei mehreren Schichten zumindest die äußerste Schicht eine dispersive zweite Phase aus mindestens einem Titansulfid und/oder Titanselenid enthält.

2. Schneidwerkzeug nach Anspruch 1, dadurch gekennzeichnet, daß der Anteil der zweiten Phase in der einzigen oder äußersten Schicht bis zu 2 Massen-%, vorzugsweise bis 1 Massen-% beträgt.

3. Schneidwerkzeug nach einem der Ansprüche 1 oder 2, dadurch gekennzeichnet, daß die zweite Phase aus TiSₓ mit x = 1 bis 2, vorzugsweise x = 1,5 bis 2 besteht.

4. Schneidwerkzeug nach einem der Ansprüche 1 bis 3, dadurch gekennzeichnet, daß die Verteilung der zweiten Phase in der Schicht im wesentlichen homogen ist oder einen Gradientenverlauf mit höheren Sulfid- oder Selenidanteilen in den oberflächennahen Zonen aufweist, wobei vorzugsweise der Anteil der zweiten Phase in einer Eindringtiefe bis zu 1 bis 2 µm von der Oberfläche aus bis zu 50 % beträgt und in größeren Eindringtiefen stufenweise oder kontinuierlich abnimmt.

5. Schneidwerkzeug nach einem der Ansprüche 1 bis 4, dadurch gekennzeichnet, daß bis zu 60 % der Selenide und/oder Sulfide durch Oxide ersetzt sind.

6. Schneidwerkzeug nach einem der Ansprüche 1 bis 5, dadurch gekennzeichnet, daß die auf das Substrat aufgetragene erste Schicht aus TiN besteht, vorzugsweise mit einer Dicke zwischen 1 und 2 µm und/oder daß die Gesamtdicke der aufgetragenen Schichten 2 bis 20 µm beträgt und/oder die Dicke der äußeren Schicht 8 µm beträgt.

7. Verfahren zur Herstellung eines Schneidwerkzeuges nach einem der Ansprüche 1 bis 6, bei dem auf einem Substratkörper aus der Gasphase eine oder mehrere Schichten mittels PVD, CVD oder PCVD abgeschieden werden, dadurch gekennzeichnet, daß in der Gasphase bei der Abscheidung der einzigen oder der letzten Schicht Schwefel- und/oder Selenverbindungen enthalten sind.

8. Verfahren nach Anspruch 7, dadurch gekennzeichnet, daß zur Co-Abscheidung von TiSₓ in der Gasphase TiCl₄ und SF₆ oder SF₄ enthalten sind.

9. Verfahren nach Anspruch 7 oder 8, dadurch gekennzeichnet, daß zur Abscheidung eines Gradienten der zweiten Phase der prozentuale Anteil der Schwefel- und/oder Selenverbindungen in der Gasphase stufenweise oder kontinuierlich erhöht wird.

10. Verfahren nach einem der Ansprüche 7 bis 9, dadurch gekennzeichnet, daß die einzige oder die letzte Schicht mit einer Wachstumsgeschwindigkeit bis zu 5 µm/h abgeschieden wird.

## Claims

1. Cutting tool, comprising a substrate body and at least one layer deposited thereon, consisting essentially of carbides, nitrides, carbonitrides, oxycarbonitrides, oxides and/or borides of at least one of the elements of the IVa to VIa group in the periodic system or of ceramic, preferably Al₂O₃,
**characterised in that**
the single layer or if there are several layers at least the outer layer contains a dispersive second phase of at least one titanium sulphide and/or titanium selenide.

2. Cutting tool according to claim 1, characterised in that the portion of the second phase in the sole or the outer layer is up to 2 mass-%, preferably up to 1 %.

3. Cutting tool according to claim 1, characterised in that the second phase consists of TiSₓ with x = 1,5 to 2.

4. Cutting tool according to claim 1, characterised in that the distribution of the second phase is essentially homogeneous in the layer or has a concentration gradient with higher portions of sulphide or selenide parts in the region near the surface whereby preferably the portion of the second phase amounts up to 50 % within a depth of penetration up to 1 to 2 µm from the surface and reduces with increasing depth of penetration step-like or continuously.

5. Cutting tool according to one of claims 1 to 4,
characterised in that up to 60 % of the selenides and/or the sulphides are substituted by oxides.

6. Cutting tool according to one of claims 1 to 4,
characterised in that the first layer deposited onto the substrate consists of TiN and has preferably a thickness between 1 and 2 µm and/or that the total thickness of the deposited layers is 2 to 20 µm and/or that the outer layer is 8 µm thick.

7. Method for producing a cutting tool according to one of the claims 1 to 6 by depositing one or more layers onto a substrate body out of the gas phase by PVD, CVD or PCVD, characterised in that the gas phase comprises sulphur- and/or selenium-compounds during the deposition of the sole or the last layer.

8. Method according to claim 7, characterised in that the gas phase comprises TiCl₄ and SF₆ or SF₄ for the co-deposition of TiSₓ.

9. Method according to claim 7 or 8, characterised in that for the deposition of a gradient of the second phase the percentage portion of the sulphur- and/or selenium-compounds in the gas phase is increased step-like or continuously.

10. Method according to one of claims 7 to 9, characterised in that the sole or the last layer is deposited with a growth velocity up to 5 µm/h.

## Revendications

1. Outil de coupe se composant d'un corps substrat et d'une couche du moins qui est déposée sur celui-ci et se compose pour l'essentiel de carbures, de nitrures, de carbonitrures, d'oxycarbonitrures, d'oxydes et/ou de borures d'au moins un des éléments du groupe IVa à VIa de la classification périodique des éléments ou d'une céramique, de préférence Al₂O₃,
**caractérisé par le fait**
que la seule couche ou, dans le cas de plusieurs couches, au moins la couche la plus extérieure comprend une deuxième phase dispersive d'un sulfure de titane et/ou séléniure de titane du moins.

2. Outil de coupe selon la revendication 1, caractérisé par le fait que la part de la deuxième phase dans la seule couche ou la couche la plus extérieure est jusqu'à 2 % en masse, de préférence jusqu'à 1 % en masse.

3. Outil de coupe selon l'une des revendications 1 ou 2, caractérisé par le fait que la deuxième phase se compose de TiSₓ avec x = 1 à 2, de préférence x = 1,5 à 2.

4. Outil de coupe selon l'une des revendications 1 à 3, caractérisé par le fait que la répartition de la deuxième phase dans la couche est pour l'essentiel homogène ou présente un gradient de concentration avec des parts plus importantes de sulfure ou de séléniure dans les zones situées près de la surface, de préférence la part de la deuxième phase étant jusqu'à 50 % dans une profondeur de pénétration jusqu'à 1 à 2 µm de la surface, et diminuant par degrés ou de manière continue dans des profondeurs de pénétration plus importantes.

5. Outil de coupe selon l'une des revendications 1 à 4, caractérisé par le fait que jusqu'à 60 % des séléniures et/ou des sulfures sont remplacés par des oxydes.

6. Outil de coupe selon l'une des revendications 1 à 5, caractérisé par le fait que la première couche appliquée sur le substrat se compose de TiN, de préférence avec une épaisseur qui est comprise entre 1 et 2 µm, et/ou que l'épaisseur totale des couches appliquées est comprise entre 2 et 20 µm, et/ou que la couche extérieure présente une épaisseur de 8 µm.

7. Procédé de fabrication d'un outil de coupe selon l'une des revendications 1 à 6, dans le cas duquel une ou plusieurs couches sont appliquées, de la phase gazeuse, sur un corps substrat au moyen du PVD, CVD ou PCVD, caractérisé par le fait que, durant la déposition de la seule ou de la dernière couche, la phase gazeuse contient des composés de soufre et/ou de sélénium.

8. Procédé selon la revendication 7, caractérisé par le fait que, pour la co-déposition de TiSₓ, la phase gazeuse contient TiCl₄ et SF₆ ou SF₄.

9. Procédé selon la revendication 7 ou 8, caractérisé par le fait que, pour la déposition d'un gradient de la deuxième phase, le pourcentage des composés de soufre et/ou de sélénium dans la phase gazeuse est augmenté par degrés ou de manière continue.

10. Procédé selon l'une des revendications 7 à 9, caractérisé par le fait que la seule ou la dernière couche est déposée avec une vitesse de croissance allant jusqu'à 5 µm/h.
